(19) Europäisches Patentamt
European Patent Office
Office européen des brevets

(11) Numéro de publication: **0 179 823**
**B1**

(12) # FASCICULE DE BREVET EUROPÉEN

(45) Date de publication du fascicule du brevet: **12.07.89**

(51) Int. Cl.⁴: **C 09 K 9/02**

(21) Numéro de dépôt: **85901950.7**

(22) Date de dépôt: **30.04.85**

(86) Numéro de dépôt international: **PCT/CH 85/00066**

(87) Numéro de publication internationale: **WO 85/05119 (21.11.85 Gazette 85/25)**

(54) **PROCEDE DE SENSIBILISATION D'UN PHOTO-CATALYSEUR D'OXYDO-REDUCTION ET PHOTO-CATALYSEUR AINSI OBTENU.**

(30) Priorité: **30.04.84 CH 2113/84**

(43) Date de publication de la demande: **07.05.86 Bulletin 86/19**

(45) Mention de la délivrance du brevet: **12.07.89 Bulletin 89/28**

(84) Etats contractants désignés: **AT BE CH DE FR GB IT LI LU NL SE**

(56) Documents cité: **US-A-4 018 508**

(73) Titulaire: **STIFTUNG, R. E., Bellerivestrasse 10, CH-8038 Zürich (CH)**

(72) Inventeur: **GRÄTZEL, Michael Institut de Chimie Physique, Ecole Polytechnique Fédérale 33, avenue de Cour, CH- 1015 Lausanne (CH)**
Inventeur: **SERPONE, Nick Institut de Chimie Physique, Ecole Polytechnique Fédérale 33, avenue de Cour, CH- 1015 Lausanne (CH)**
Inventeur: **DUONGHONG, Dung Institut de Chimie Physique, Ecole Polytechnique Fédérale 33, avenue de Cour, CH- 1015 Lausanne (CH)**

(74) Mandataire: **Vuille, Roman, c/o KIRKER & Cie S.A. 14, rue du Mont- Blanc Case Postale 872, CH- 1211 Genève 1 (CH)**

**EP 0 179 823 B1**

Il est rappelé que: Dans un délai de neuf mois à compter de la date de publication de la mention de la délivrance du brevet europeen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

LIBER, STOCKHOLM 1989

## Description

L'invention se rapporte à un procédé de sensibilisation d'un photo-catalyseur d'oxydo-réduction à base de semi-conducteur, au photo-catalyseur ainsi obtenu ainsi qu'à l'utilisation dudit photo-catalyseur pour la photo-oxydation de liquides aqueux ou organiques aqueux ou la photo-décomposition de liquides aqueux en lumière visible. Un des buts visés sera la photo production d'hydrogène. L'objet de la présente invention est défini aux revendications.

Dans les cellules photoélectrochimiques ou dans les systèmes générateurs d'hydrogène par voie photochimique, notamment les systèmes basés sur la conversion de l'énergie solaire, on se heurte présentement au problème du rendement de cette conversion d'énergie. Diverses solutions sont actuellement proposées pour y remédier, telles que la modification de la surface du photo-catalyseur à l'aide de colorants photo-actifs ou le dopage dudit photo-catalyseur à l'aide de substances appropriées.

Afin de résoudre les problèmes du rendement de la conversion de l'énergie solaire dans des applications telles que la photo-décomposition de liquides aqueux, l'intérêt serait de posséder des photo-catalyseurs présentant une bande d'absorption lumineuse dans ou voisine de la lumière visible. Il a été observé qu'en effectuant la complexation d'oxyde de titane ($TiO_2$) à l'aide d'un complexe de titane et de 8-hydroxyquinoline, on parvenait à sensibiliser les particules d'oxyde de titane de façon à permettre leur emploi en lumière visible, [voir à ce sujet J. Am. Chem. Soc. 105, 5695 (1983)]. L'emploi d'un tel photo-catalyseur est cependant limité par le fait qu'on ne peut pas produire d'oxygène par photo-décomposition de l'eau.

La présente invention a pour but de proposer un photo-catalyseur sensibilisé permettant de générer, avec un rendement satisfaisant, de l'hydrogène et de l'oxygène par photo-décomposition de liquides aqueux en lumière visible. On y parvient en effectuant la sensibilisation d'un photo-catalyseur d'oxydo-réduction à base de semi-conducteur à l'aide du procédé revendiqué.

Il a été en effet découvert, de façon surprenante, qu'en fixant à la surface d'un photo-catalyseur d'oxydo-réduction à base de semi-conducteur, tel l'oxyde de titane par exemple, un chromophore constitué d'un fragment d'un complexe d'un métal de transition et du ligand di-isopropyl-2,2'-bipyridyl-4,4'-dicarboxylate, on parvenait à l'effet souhaité.

Selon l'invention, ledit chromophore est le plus généralement constitué d'un fragment d'un complexe de ruthénium, de chrome ou de fer, de préférence d'un fragment de complexe de formule

$RuL_2^{++}$

dans laquelle le symbole L représente le ligand di-isopropyl-2,2'-bipyridyl-4,4'-dicarboxylate. Un tel chromophore est parfaitement stable dans les conditions d'emploi du photo-catalyseur et provoque le déplacement de l'absorption lumineuse du photo-catalyseur au-delà de 600 nm. La stabilité d'un tel chromophore peut s'expliquer par la fixation chimique du fragment de complexe

$RuL_2^{++}$

à la surface des particules d'oxyde de titane, plus précisément par la formation de liaisons Ru-O-Ti comme illustré ci-dessous

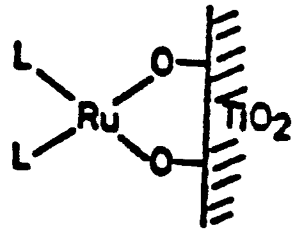

(L = di-isopropyl-2,2'-bipyridyl-4,4'-dicarboxylate).

Il a été constaté qu'à l'aide d'un photo-catalyseur ainsi sensibilisé, on pouvait obtenir, avec un rendement satisfaisant, de l'hydrogène par irradiation de liquides aqueux ou aqueux organiques à une longueur d'onde comprise entre 590 et 665 nm. De façon tout aussi efficace, on a effectué la photo-décomposition de l'eau en hydrogène et oxygène respectivement.

Selon l'invention, la sensibilisation du photo-catalyseur s'effectue par fixation du chromophore choisi à la surface du semi-conducteur à l'aide de toute méthode appropriée. Selon une mise en oeuvre préférentielle du procédé de l'invention, on irradie le photo-catalyseur en présence d'une solution aqueuse acide d'un complexe de formule

$(RuL_3)^{++}2X^-$

dans laquelle L est défini comme précédemment et X représente un atome d'halogène, tel le chlore par exemple.

Le catalyseur d'oxydo-réduction à base de $TiO_2$ peut être avantageusement préparé selon les méthodes décrites dans la littérature; la solution de complexe défini ci-dessus peut être obtenue à partir de produits du commerce.

Pour l'irradiation, on met en suspension la quantité choisie de catalyseur dans une solution aqueuse diluée de complexe, de l'ordre de 0,5 à 5 x $10^{-4}$ molaire selon les cas. Si nécessaire, le pH de la solution est ajusté à la valeur prescrite, généralement comprise entre 1 et 3, par addition d'acide. On opère de préférence à un pH voisin de 2, pour une concentration de complexe voisine de 1,5 x $10^{-4}$ molaire. Avant l'irradiation proprement dite, on procède au dégazage de l'appareillage, par exemple à l'aide d'un gaz inerte tel l'argon. La suspension ainsi préparée est ensuite portée à la température choisie, le plus généralement comprise entre 50°C et la température

d'ébullition: on travaille de préférence à environ 100°C. L'irradiation s'effectue à l'aide des moyens classiques, telle une lampe UV communément utilisée en laboratoire; elle est poursuivie durant le temps nécessaire à la disparition quasi totale du complexe initialement mis en solution, généralement durant 24 heures ou plus.

Le photo-catalyseur ainsi sensibilisé est alors recueilli par filtration ou ultracentrifugation par exemple, purifié et finalement séché selon les techniques usuelles. L'expérience a montré qu'un tel photo-catalyseur demeure stable et actif dans les conditions de son emploi, même pour des périodes de plusieurs semaines.

Selon l'invention, un tel photo-catalyseur sensibilisé peut être avantageusement utilisé pour générer de l'hydrogène gazeux par irradiation de liquides aqueux en lumière visible. A cet effet, on peut par exemple procéder à la photo-oxydation d'un liquide aqueux organique telle une solution aqueuse diluée de triéthanolamine par exemple, le composé organique présent jouant le rôle de donneur d'électron sacrifié.

Un tel catalyseur peut être tout aussi avantageusement utilisé pour la photo-décomposition de liquides aqueux, l'eau distillée par exemple, en oxygène et hydrogène respectivement, par irradiation en lumière visible.

Dans les cas mentionnés di-dessus, l'irradiation peut être avantageusement effectuée avec une lumière de longueur d'onde supérieure à 400 nm, par exemple de l'ordre de 450 nm, voire 500 nm ou plus. Ladite irradiation s'effectue en outre le plus généralement à la température d'ébullition du liquide aqueux choisi, par exemple dans un appareillage semblable à celui utilisé pour la sensibilisation du photo-catalyseur.

Les exemples ci-après illustreront de façon plus détaillée certaines des mises en oeuvre de l'invention (températures indiquées en degrés centigrades).

**Exemple 1**

**Sensibilisation d'un catalyseur d'oxydo-réduction à base d'oxyde de titane**

a) Préparation du catalyseur ($TiO_2/Pt/RuO_2$) matières de départ:

- $(RuL_3)Cl_2$ (L = di-isopropyl-2,2'-bipyridyl-4,4'-dicarboxylate), préparé selon J. Am. Chem. Soc. 105, 5695 (1983)
- $TiO_2$ (anatase; contenu en Nb environ 600 ppm; taille des cristaux primaires 100 A; BET 145 $m^2/g$)
- $TiCl_4$ purifié par distillation sous vide selon J. Am. Chem. Soc. 105, 6547 (1983)

On a premièrement procédé à l'hydrolyse, dans l'eau à 0°, d'une quantité de $TiCl_4$ en présence de $NbCl_2$ en quantité calculée pour obtenir un dopage de 0,1 % de Nb. La solution d'hydrolyse (pH 0,5) a ensuite été soumise à dialyse jusqu'à obtention d'un pH 2.

A la solution acide ainsi préparée, on a ensuite ajouté $H_2PtCl_6$ et $RuO_4$ respectivement, en quantité calculée pour obtenir une charge des particules de $TiO_2$ de 0,5 % en Pt et $RuO_2$ respectivement. La solution résultante a ensuite été évaporée à sec à 60° et conservée durant 24 heures à cette température. A ce stade des opérations, on a observé une décomposition spontanée de $RuO_4$ en $RuO_2$ (dépôts noirs).

50 mg du résidu sec ainsi obtenu ont été mis en suspension dans 25 ml d'eau et soumis à une irradiation (lampe au xénon XBO 450 Watt), après dégazéification préalable de la suspension avec de l'argon. La réduction des anions hexachloroplatinate a été effectuée conformément à la méthode décrite dans J. Am. Chem. Soc. 100, 4318 (1978), l'irradiation étant interrompue après environ 30 min., des apparition d'hydrogène dans la phase gazeuse.

b) sensibilisation du catalyseur ($TiO_2/Pt/RuO_2$)

A la suspension de catalyseur (50 mg) obtenue sous lettre a, étendue à 40 ml, on a ajouté le complexe de ruthénium $(RuL_3)Cl_2$ en quantité calculée pour obtenir une concentration dudit complexe de 1,5 x $10^{-4}$ molaire, le pH de la suspension étant ajusté à 2 à l'aide HCl.

Un ballon de 50 ml contenant la suspension résultante a ensuite été connecté à un appareil muni d'un réfrigérant, relié lui-même à un second récipient contenant 30 ml d'eau par l'intermédiaire d'un tube capillaire, l'ensemble étant alors soumis à dégazéification avec de l'argon. La suspension a ensuite été portée à ébullition, sous agitation permanente et irradiée à l'aide d'une lampe au xénon (XBO 450 Watt), munie d'un filtre UV (420 nm) et d'une double paroi avec circulation d'eau.

L'irradiation de la suspension a été maintenue durant 24 heures à la température d'ébullition et les particules de catalyseur sensibilisé récupérées par ultra-centrifugation. Durant l'irradiation, le complexe $(RuL_3)Cl_2$ a progressivement disparu de la solution, ce phénomène s'accompagnant d'une coloration intense des particules de $TiO_2/Pt/RuO_2$. La solution résultante a été caractérisée par son spectre d'absorption (voir figure 1) qui confirme la disparition quasi complète de l'absorption typique du complexe $(RuL_3)Cl_2$ à 466 nm (concentration inférieure à 5 %). Le maximum d'absorption à 305 nm de ladite solution a été attribué au ligand di-isopropyl-2,2-bipyridyl-4,4'-dicarboxylate.

La fixation du chromophore $RuL_2^{++}$ a été éprouvée à l'aide de lavages successifs des particules avec $H_2O$ et du méthanol.

Dans une seconde expérience, l'irradiation d'une suspension de 25 mg de catalyseur $TiO_2/Pt/RuO_2$ dans 40 ml d'eau (pH 2) a été poursuivie durant 36 heures à 100°C. Les particules de catalyseur sensibilisé ont ensuite été filtrées, lavées avec $H_2O$, séchées à l'air et le

catalyseur ainsi purifié caractérisé par son spectre de réflexion (figure 2). Ce spectre se caractérise par un maximum d'absorption à 480 nm suivi d'une queue se poursuivant au-delà de 600 nm. Cette absorption caractéristique a été attribuée au chromophore $RuL_2^{++}$, lié chimiquement aux particules de $TiO_2$ comme illustré plus haut.

**Exemple 2**

**Utilisation d'un catalyseur d'oxydo-réduction sensibilisé pour la photo-réduction de l'eau**

5 ml d'une solution $10^{-2}$ molaire de triéthanolamine dans l'eau (pH 10) ont été irradiés à 25° dans un appareil tel que décrit à l'exemple 1, en présence de 10 mg de catalyseur $TiO_2/Pt/RuO_2$ sensibilisé à l'aide de $RuL_2^{++}$: irradiation à λ supérieur à 405 nm - lampe au xénon XBO 450 Watt (intensité 200 mW/cm²). On a ainsi généré de l'hydrogène gazeux à raison de 0,93 ml/h.

On a observé un abaissement de 20 % du rendement en hydrogène gazeux lors de l'emploi d'un filtre UV de 465 nm. En irradiant à λ supérieur à 590 nm, l'hydrogène gazeux a été généré à raison de 50 µl/h.

**Exemple 3**

**Utilisation d'un catalyseur d'oxydo-reduction sensibilisé pour la photo-décomposition de l'eau**

Une suspension de 50 mg de catalyseur $TiO_2/Pt/RuO_2$ sensibilisé à l'aide de $RuL_2^{++}$ dans 40 ml d'eau (pH 2) a été irradiée à 100° dans un appareil tel que décrit à l'exemple 1: λ supérieur à 420 nm. La génération d'hydrogène gazeux s'est effectuée initialement à raison de 30 µl/h, conduisant à un volume de 400 µl après 20 heures d'irradiation.

L'analyse, par chromatographie, du gaz en cours d'irradiation (échantillon de 400 µl prélevé après 12 heures) a montré que l'on était en présence d'un mélange gazeux $H_2/O_2$ dans un rapport quasi stoechiométrique: 240 µl (± 20)$H_2$ et 120 µl (± 10)$O_2$, le solde étant attribué à la correction due à la présence d'air.

Il a été en outre observé que le catalyseur sensibilisé demeurait actif après avoir été irradié durant plus de 2 semaines à 100° dans des conditions telles que décrites ci-dessus.

**Revendications**

1. Photo-catalyseur d'oxydo-réduction à base de semi-conducteur, caractérisé en ce qu'il comporte à sa surface un chromophore constitué d'un fragment d'un complexe d'un métal de transition et du ligand di-isopropyl-2,2'-bipyridyl-4,4'-dicarboxylate.

2. Photo-catalyseur selon la revendication 1, caractérisé en ce que ledit catalyseur est à base d'oxyde de titane et que le chromophore est constitué d'un fragment d'un complexe de ruthénium, de chrome ou de fer.

3. Photo-catalyseur selon l'une des revendications 1 et 2, caractérisé en ce que ledit chromophore est constitué d'un fragment de complexe de formule

$RuL_2^{++}$

dans laquelle le symbole L représente le ligand di-isopropyl-2,2'-bipyridyl-4,4'-dicarboxylate.

4. Procédé de sensibilisation d'un photo-catalyseur d'oxydo-réduction à base de semi-conducteur, caractérisé en ce que l'on fixe à sa surface un chromophore constitué d'un fragment d'un complexe d'un métal de transition et du ligand di-isopropyl-2,2'-bipyridyl-4,4'-dicarboxylate provoquant un déplacement de la bande d'absorption lumineuse du catalyseur vers la lumière visible.

5. Procédé selon la revendication 4, caractérisé en ce que ledit catalyseur est à base d'oxyde de titane et le chromophore est constitué d'un fragment d'un complexe de ruthénium, de chrome ou de fer.

6. Procédé selon l'une des revendications 4 et 5, caractérisé en ce que ledit chromophore est constitué d'un fragment de complexe de formule

$RuL_2^{++}$

dans laquelle le symbole représente le ligand di-isopropyl-2,2'-bipyridyl-4,4'-dicarboxylate.

7. Procédé selon la revendication 6, caractérisé en ce qu'on irradie le photo-catalyseur en présence d'une solution aqueuse acide d'un complexe de formule

$(RuL_3)^{++}2X^-$

dans laquelle le symbole L est défini à la revendication 6 et X représente un atome d'halogène.

8. Procédé selon la revendication 7, caractérisé en ce que l'irradiation s'effectue à une température comprise entre 50°C et la température d'ébullition de la solution de complexe et que ladite solution possède un pH compris entre 1 et 3.

9. Utilisation d'un photo-catalyseur d'oxydo-réduction selon l'une des revendications 1 à 3 pour la photo-oxydation de liquides aqueux ou organiques aqueux en lumière visible.

10. Utilisation d'un photo-catalyseur d'oxydo-réduction selon l'une des revendications 1 à 3 pour la photo-décomposition de liquides aqueux en lumière visible.

**Patentansprüche**

1. Oxydation-Reduktions-Photokatalysator auf Halbleiterbasis, dadurch gekennzeichnet, dass seine Oberfläche einen Farbträger enthält, bestehend aus einem Fragment eines Komplexes eines Übergangsmetalls und eines Diisopropyl-2,2'-Bipyridyl-4,4'-Dikarboxylat-Liganden.

2. Photokatalysator nach Patentanspruch 1, dadurch gekennzeichnet, dass besagter Katalysator ein Katalysator auf Titanoxydbasis ist, und dass der Farbträger ein Fragment eines Ruthenium-, Chrom- oder Eisenkomplexes enthält.

3. Photokatalysator nach Patentanspruch 1 oder 2, dadurch gekennzeichnet, dass besagter Farbträger aus einem Komplexfragment nach der Formel

$RuL_2^{++}$

besteht, in dem das Symbol L den Diisopropyl-2,2'-Bipyridyl-4,4'-Dikarboxylat-Liganden darstellt.

4. Sensibilisierungsverfahren eines Oxydation-Reduktions-Photo-Katalysators auf Halbleiterbasis dadurch gekennzeichnet, dass man auf seiner Oberfläche einen Farbträger anlagert, bestehend aus einem Fragment eines Komplexes eines Übergangsmetalls und eines Diisopropyl-2,2'-Bipyridyl-4,4'-Dikarboxylat-Liganden, der eine Verschiebung des Lichtabsorptionsbandes des Katalysators in Richtung des sichtbaren Lichts bewirkt.

5. Verfahren nach Patentanspruch 4, dadurch gekennzeichnet, dass besagter Katalysator ein Katalysator auf Titanoxydbasis ist, und dass der Farbträger ein Fragment eines Ruthenium-, Chrom- oder Eisenkomplexes enthält.

6. Verfahren nach Patentanspruch 4 und 5, dadurch gekennzeichnet, dass besagter Farbträger aus einem Komplexfragment nach der Formel

$RuL_2^{++}$

besteht, in dem das Symbol L den Diisopropyl-2,2'-Bipyridyl-4,4'-Dikarboxylat-Liganden darstellt.

7. Verfahren nach Patentanspruch 6, dadurch gekennzeichnet, dass man den Photokatalysator in Gegenwart einer wässrigen Säurelösung eines Komplexes mit der Formel

$(RuL_3)^{++}2X^-$ ·

bestrahlt, in dem das Symbol L im Patentanspruch 6 definiert wurde, und X ein Halogenatom darstellt.

8. Verfahren nach Patentanspruch 7, dadurch gekennzeichnet, dass die Bestrahlung bei einer zwischen 50°C und der Siedetemperatur der Komplexlösung liegenden Temperatur erfolgt, und dass der pH-Wert der besagten Lösung zwischen 1 und 3 liegt.

9. Verwendung eines Oxydation-Reduktions-Photokatalysators nach einem der Patentansprüche 1 bis 3 für die Photooxydation der wässrigen oder wässrig-organischen Lösungen bei sichtbarem Licht.

10. Verwendung eines Oxydation-Reduktions-Photokatalysators nach einem der Patentansprüche 1 bis 3 für die Photozerlegung bei sichtbarem Licht.

**Claims**

1. A semiconductor-based redox photocatalyst, characterized in that it has, on its surface, a chromophore consisting of a fragment of a complex of a transition metal and the ligand 2,2'-diisopropylbipyridyl-4,4'-dicarboxylate.

2. A photocatalyst according to Claim 1, characterized in that the said catalyst is based on titanium oxide and in that the chromophore consists of a fragment of a ruthenium, chromium or iron complex.

3. A photocatalyst according to Claim 1 or Claim 2, characterized in that the said chromophore consists of a complex fragment of the formula

$RuL_2^{++}$

in which the symbol L represents the ligand 2,2'-diisopropylbipyridyl-4,4'-dicarboxylate.

4. A process for the sensitization of a semiconductor-based redox photocatalyst, characterized in that a chromophore consisting of a fragment of a complex of a transition metal and the ligand 2,2'-diisopropylbipyridyl-4,4'-dicarboxylate is fixed to its surface, causing a shift in the light absorption band of the catalyst towards visible light.

5. The process according to Claim 4, characterized in that the said catalyst is based on titanium oxide and the chromophore consists of a fragment of a ruthenium, chromium or iron complex.

6. The process according to Claim 4 or Claim 5, characterized in that the said chromophore consists of a complex fragment of the formula

$RuL_2^{++}$

in which the symbol L represents the ligand 2,2'-diisopropylbipyridyl-4,4'-dicarboxylate.

7. The process according to Claim 6, characterized in that the photocatalyst is irradiated in the presence of an acid aqueous solution of a complex of the formula

$(RuL_3)^{++}2X^-$

in which the symbol L is defined in Claim 6 and X represents a halogen atom.

8. The process according to Claim 7, characterized in that the irradiation is carried out at a temperature of between 50°C and the boiling

point of the complex solution and in that the said solution has a pH of between 1 and 3.

9. Use of a redox photocatalyst according to any one of Claims 1 to 3 for the photooxidation of aqueous or aqueous-organic liquids in visible light.

10. Use of a redox photocatalyst according to any one of Claims 1 to 3 for the photodecomposition of aqueous liquids in visible light.

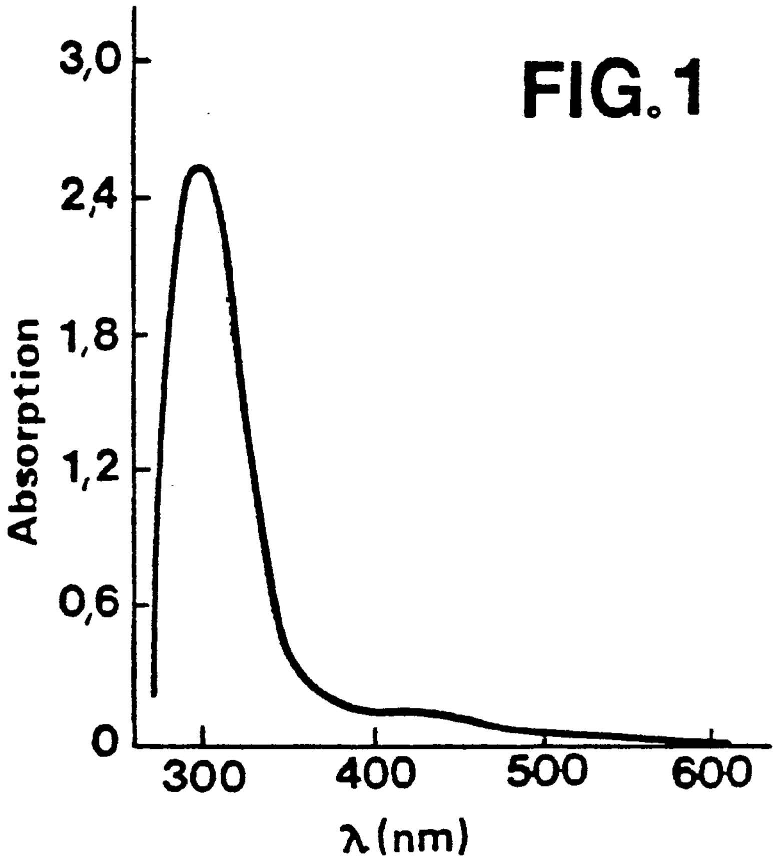

3,0
2,4
1,8
1,2
0,6
0
Absorption
300
400
500
600
λ (nm)


FIG. 1

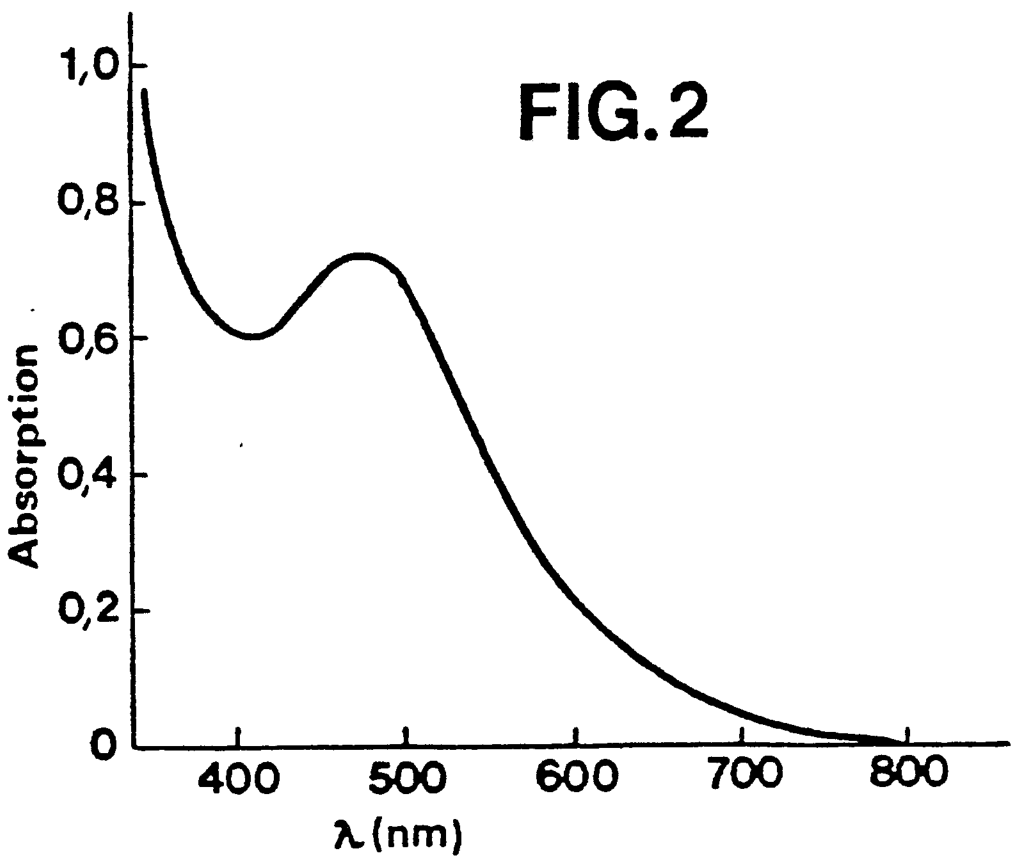

1,0
0,8
0,6
0,4
0,2
0
Absorption
400
500
600
700
800
λ (nm)


FIG. 2